# EUROPÄISCHE PATENTANMELDUNG

(11) **EP 4 012 436 A1**
(43) Veröffentlichungstag der Anmeldung: **15.06.2022**
(21) Anmeldenummer: 20213418.5
(22) Anmeldetag: 11.12.2020
(51) Int. Cl.: G01R 33/565

(54) **MAGNETRESONANZTOMOGRAPHIE MIT SIMULATIONSGESTÜTZTER STÖRUNGSREDUKTION**

(71) Anmelder: Siemens Healthcare GmbH, 91052 Erlangen (DE)
(72) Erfinder: Schneider, Rainer, 91054 Erlangen (DE)

(57) **Zusammenfassung**

Eine MR-Sequenz für ein Objekt (100) wird mittels einer Recheneinheit (5) simuliert, um ein Simulationssignal zu bestimmen, welches einen Verlauf einer Quermagnetisierung von Kernspins betrifft. Abhängig von dem Simulationssignal wird ein Ruheabschnitt der MR-Sequenz bestimmt, während dem eine zu erwartende MR-Signalamplitude stets kleiner oder gleich einem vorgegebenen Grenzwert ist. Es wird eine MR-Aufnahme gemäß der MR-Sequenz durchgeführt, wobei während eines dem Ruheabschnitt entsprechenden Analysezeitraums mittels einer Hauptempfangsantenne (14, 50) und wenigstens einer Hilfsempfangsantenne (60) jeweils ein Analysesignal empfangen wird und abhängig von den Analysesignalen wird wenigstens ein Entstörungsparameter bestimmt. Mittels der Hauptempfangsantenne (14, 50) wird ein MR-Signal empfangen und mittels der wenigstens einen Hilfsempfangsantenne (60) wird jeweils ein Störsignal empfangen. Ein entstörtes MR-Signal wird basierend auf dem MR-Signal, den Störsignalen und dem wenigstens einen Entstörungsparameter erzeugt.

## Beschreibung

Die vorliegende Erfindung betrifft ein Verfahren zum Betreiben eines Magnetresonanztomographiesystems, ein Magnetresonanztomographiesystem sowie ein Computerprodukt.

Systeme zur Magnetresonanztomographie, MRT, sind bildgebende Vorrichtungen, die zur Abbildung eines Untersuchungsobjekts Kernspins des Untersuchungsobjekts mit einem starken äußeren Magnetfeld ausrichten und durch ein magnetisches Wechselfeld zur Präzession um die entsprechende Ausrichtung anregen. Die Präzession beziehungsweise die Rückkehr der Spins aus diesem angeregten Zustand in einen Zustand mit geringerer Energie wiederum erzeugt als Antwort ein magnetisches Wechselfeld, das über Empfangsantennen detektiert werden kann.

Mithilfe von magnetischen Gradientenfeldern kann den Signalen eine Ortscodierung aufgeprägt werden, die nachfolgend eine Zuordnung von dem empfangenen Signal zu einem Volumenelement des Untersuchungsobjekts ermöglicht. Das empfangene Signal kann dann ausgewertet werden, beispielsweise um eine dreidimensionale bildgebende Darstellung des Untersuchungsobjekts bereitzustellen. Als Empfangsantennen können beispielsweise lokale Empfangsantennen, sogenannte Lokalspulen, verwendet werden, die zur Erzielung eines besseren Signal-Rausch-Verhältnisses, SNR, unmittelbar an dem Untersuchungsobjekt angeordnet werden können. Die Empfangsantennen können aber auch in der Umgebung des Untersuchungsobjekts angeordnet sein oder beispielsweise in einer Patientenliege verbaut sein.

Die für die Bildgebung zu empfangenden Magnetresonanz-,MR-, Signale sind extrem schwach, sodass bei bekannten MRT-Systemen eine Abschirmung externer Störsignale erforderlich ist, um ein ausreichendes SNR zu erreichen. Dazu werden insbesondere aufwendige Abschirmkabinen installiert, um die störenden Immissionen zu reduzieren. Dies führt zu erheblichen Kosten und baulichen Einschränkungen aufgrund des entsprechenden Platzbedarfs.

Im Dokument WO 2019/068687 A2 werden ein Magnetresonanztomograph mit aktiver Störunterdrückung und ein entsprechendes Verfahren beschrieben. Dabei ist eine erste Empfangsantenne zum Empfang eines Magnetresonanzsignals aus einem Patienten vorgesehen und eine zweite Empfangsantenne zum Empfang eines Störsignals. Ein mit den Empfangsantennen verbundener Empfänger ist dazu ausgelegt, das mit der zweiten Empfangsantenne empfangene Störsignal in dem von der ersten Empfangsantenne empfangenen Magnetresonanzsignal zu unterdrücken. Dazu wird das Störsignal während der MRT-Sequenzen zur Signalakquisition bestimmt, wobei Zeitabschnitte genutzt werden können, in denen kein MR-Signal zur Bildgebung erwartet wird. Eine Entstörsteuerung kann dann die Signale der ersten Empfangsantenne und der zweiten Empfangsantenne gewichtet kombinieren, um die Energie des Störsignals in dem kombinierten Signal zu minimieren.

Da diese Abschnitte je nach verwendeter MRT-Sequenz unterschiedlich lang sind und zu unterschiedlichen Zeiten auftreten, muss das Vorgehen zur Entstörung individuell auf jede MRT-Sequenz angepasst werden, was zu einem erhöhten Aufwand führt. Dazu kommt, dass die zugrundeliegenden physikalischen Systeme sehr komplex sind, sodass die Vorhersage passender Abschnitte schwierig und dadurch unzuverlässig ist.

Vor diesem Hintergrund ist es eine Aufgabe der vorliegenden Erfindung, ein verbessertes Konzept für ein MRT-System beziehungsweise für ein Verfahren zum Betreiben eines solchen anzugeben, durch das der Aufwand für eine Abschirmung externer Störsignale reduziert werden kann und gleichzeitig eine hohe Effektivität der Störungsreduzierung, insbesondere bei möglichst geringem Anpassungsaufwand, möglich ist.

Diese Aufgabe wird vorliegend gelöst durch den jeweiligen Gegenstand der unabhängigen Ansprüche. Vorteilhafte Weiterbildungen und bevorzugte Ausführungsformen sind Gegenstand der abhängigen Ansprüche.

Das verbesserte Konzept beruht auf der Idee, den zeitlichen und räumlichen Verlauf der Quermagnetisierung eines Ensembles von Kernspins eines zu untersuchenden Objekts während einer MR-Sequenz zu simulieren und basierend darauf einen Ruheabschnitt der MR-Sequenz zu bestimmen. Entstörungsparameter zur Unterdrückung von externen Störeinflüssen werden basierend auf Signalen bestimmt, die während eines dem Ruheabschnitt entsprechenden Analysezeitraums einer darauffolgenden MR-Aufnahme empfangen werden.

Gemäß dem verbesserten Konzept wird ein Verfahren zum Betreiben eines MRT-Systems angegeben, wobei das MRT-System eine Hauptempfangsantenne und wenigstens eine außerhalb eines Untersuchungsbereichs des MRT-Systems angeordnete Hilfsempfangsantenne aufweist. Mittels einer Recheneinheit, beispielsweise des MRT-Systems, wird eine Simulation einer vorgegebenen MR-Sequenz eines Objekts durchgeführt, um wenigstens ein Simulationssignal zu bestimmen, welches einen zeitlichen und räumlichen Verlauf einer Quermagnetisierung eines Ensembles von Kernspins des Objekts betrifft. Mittels der Recheneinheit wird abhängig von dem wenigstens einen Simulationssignal ein Ruheabschnitt der MR-Sequenz bestimmt, wobei während des Ruheabschnitts ein Absolutwert einer zu erwartenden MR-Signalamplitude stets kleiner oder gleich einem vorgegebenen Grenzwert ist. Mittels des MRT-Systems wird eine MR-Aufnahme des Objekts gemäß der MR-Sequenz durchgeführt, wobei während eines dem Ruheabschnitt entsprechenden Analysezeitraums, insbesondere der MR-Sequenz beziehungsweise der MR-Aufnahme, mittels der Hauptempfangsantenne und der wenigstens einen Hilfsempfangsantenne jeweils ein Analysesignal empfangen wird. Abhängig von den Analysesignalen der Hauptempfangsantenne und der wenigstens einen Hilfsempfangsantenne wird, beispielsweise mittels einer Entstörungseinrichtung des MRT-Systems, wenigstens ein Entstörungsparameter bestimmt. Mittels der Hauptempfangsantenne wird während der MR-Aufnahme außerhalb des Analysezeitraums ein MR-Signal empfangen und mittels der wenigstens einen Hilfsempfangsantenne wird außerhalb des Analysezeitraums während der MR-Aufnahme jeweils ein Störsignal empfangen. Ein entstörtes MR-Signal wird, insbesondere mittels der Entstörungseinrichtung, basierend auf dem MR-Signal, den Störsignalen und dem wenigstens einen Entstörungsparameter erzeugt.

Abhängig von dem entstörten Magnetresonanz-, MR-, Signal kann dann beispielsweise ein Ortsraumbild erzeugt werden, das insbesondere das Objekt darstellt, beispielsweise mittels der Recheneinheit.

Der Untersuchungsbereich des MRT-Systems kann beispielsweise innerhalb eines Patiententunnels des MRT-Systems liegen. Die wenigstens eine Hilfsempfangsantenne ist dann beispielsweise außerhalb des Patiententunnels oder in der Nähe einer Öffnung des Patiententunnels angeordnet. Als Öffnung des Patiententunnels kann dabei insbesondere eine Öffnung angesehen werden, durch die eine Patientenliege mit einem Patienten in den Patiententunnel eingefahren oder aus dem Patiententunnel herausgefahren werden kann. Ist die wenigstens eine Hilfsempfangsantenne in der Nähe einer Öffnung angeordnet, so kann dies beispielsweise einem Abstand von weniger als 0,1 m, weniger als 0,2 m, weniger als 0,5 m, weniger als 1 m oder weniger als 2m entsprechen. In der Nähe der Öffnung kann auch einem Abstand von der Öffnung entsprechen, der weniger als ein Viertel einer Wellenlänge einer Radiowelle in der Luft mit einer Lamorfrequenz des MRT-Systems entspricht oder weniger als die Hälfte der Wellenlänge.

Im Allgemeinen, insbesondere außerhalb des Analysezeitraums, empfängt die Hauptempfangsantenne bevorzugt das MR-Signal, das aber in der Gegenwart von Störquellen in der Regel auch einen kleinen Anteil des Störsignals aufweist. Umgekehrt empfängt in der Regel die wenigstens eine Hilfsempfangsantenne nicht nur das Störsignal, sondern auch einen geringen Teil des MR-Signals. Der Einfachheit halber wird dennoch im Folgenden das von der Hauptempfangsantenne außerhalb des Analysezeitraums empfangene Signal als MR-Signal und das von der wenigstens einen Hilfsempfangsantenne empfangene Signal als Störsignal bezeichnet.

Die Entstörungsparameter können beispielsweise Gewichtungsfaktoren für die Hauptempfangsantenne und die wenigstens eine Hilfsempfangsantenne beinhalten. Gemäß den Gewichtungsfaktoren kann dann eine Kombination des MR-Signals mit den Störsignalen als entstörtes MR-Signal erzeugt werden. Die Kombination kann einer Linearkombination entsprechen, es sind jedoch auch nicht-lineare Kombinationen denkbar. Mit anderen Worten dienen die Gewichtungsfaktoren zur gewichteten Summation von Signalen, die den jeweiligen Ausgangssignalen der Hauptempfangsantenne und der wenigstens einen Hilfsempfangsantenne entsprechen oder davon abhängen. Die Gewichtungsfaktoren können also beispielsweise zur gewichteten Summation des MR-Signals mit den Störsignalen dienen. Beispielsweise kann die Entstörungseinrichtung eine Summationseinrichtung aufweisen, die eine von den jeweiligen Gewichtungsfaktoren abhängige Kombination, beispielsweise Linearkombination, aus den Ausgangssignalen der Hilfsempfangsantennen und der Hauptempfangsantenne bilden kann.

Die Gewichtungsfaktoren können dabei derart bestimmt werden, dass der Einfluss einer oder mehrerer externer Störquellen wenigstens zum Teil unterdrückt werden kann, dass also die Kombination des MR-Signals mit den Störsignalen oder, mit anderen Worten, ein entstörtes MR-Signal, einen möglichst geringen Einfluss der einen oder der mehreren Störquellen aufweist.

Dazu kann die Entstörungseinrichtung die ersten Gewichtungsfaktoren beispielsweise derart variieren, dass der Einfluss der einen oder mehreren Störquellen in der resultierenden Kombination der Analysesignale möglichst gering ist, also minimiert wird. Da gemäß der Simulation während des Analysezeitraums kein MR-Signal zu erwarten ist, kann hier eine besonders zuverlässige Kompensation der Störeinflüsse erzielt werden. Die Entstörungseinrichtung kann beispielsweise die Gewichtungsfaktoren variieren, um eine Energie der resultierenden Kombination insgesamt zu minimieren. Die Gewichtungsfaktoren können insbesondere auch komplex sein, um eine Phasenverschiebung zu berücksichtigen. Die Anhand der Optimierung der Kombination der Analysesignale erhaltenen Gewichtungsfaktoren können zu einem späteren Zeitpunkt zur Kombination des MR-Signals mit den Störsignalen benutzt werden.

Durch das verbesserte Konzept wird also die Simulation der MR-Sequenz herangezogen, um optimale Zeiträume zum Bestimmen der Entstörungsparameter während der konkreten MR-Sequenz vorab zu bestimmen. Dadurch können die Bedingungen zur Bestimmung der Entstörungsparameter optimiert werden, sodass eine besonders zuverlässige Kompensation von Störeinflüssen ermöglicht wird.

Schließlich kann durch das verbesserte Konzept auch auf die Verwendung von Abschirmkabinen zum Abschirmen von externen Störeinflüssen verzichtet werden oder die Abschirmkabinen können einfacher ausgestaltet werden, was Bauraum und/oder Kosten einsparen kann.

Die Kombination des MR-Signals mit den Störsignalen kann als lineare Kombination, also Linearkombination, ausgestaltet sein. Denkbar sind aber auch nicht-lineare Kombinationen in Abhängigkeit von den Gewichtungsfaktoren.

Die wenigstens eine Hilfsantenne kann insbesondere zwei oder mehr Hilfsantennen beinhalten. Dementsprechend kann in solchen Ausführungsformen die Entstörungsvorrichtung solche Störsignale mit besonders großer Amplitude gegenüber schwächeren besonders stark gewichten, da sich durch einen besonders großen Abstand des Signalpegels gegenüber dem statistischen Hintergrundrauschen stärkere Störsignale besonders gut unterdrücken lassen.

Die Recheneinheit kann die Entstörungseinrichtung beinhalten oder separat zu dieser ausgebildet sein. Die Entstörungseinrichtung kann in letzterem Falle selbst eine weitere Recheneinheit beinhalten. Die Entstörungseinrichtung, insbesondere die weitere Recheneinheit, kann beispielsweise eine programmierbare Logikeinheit, beispielsweise ein feldprogrammierbares Gate-Array, FPGA, oder einen digitalen Signalprozessor, DSP, beinhalten. Die Erzeugung des entstörten Magnetresonanzsignals kann dann beispielsweise in Echtzeit ausgeführt werden.

Es ist aber auch möglich, dass die Entstörungsvorrichtung einen Speicher aufweist, der die Störsignale sowie das MR-Signal zunächst speichert. Die Erzeugung des entstörten MR-Signals erfolgt dann beispielsweise erst zu einem späteren Zeitpunkt mit einer Verzögerung beispielsweise von einer Dauer einer Echosequenz, einer Anregungssequenz oder einer ganzen Bilderfassung einer einzelnen Schicht oder der gesamten Bilderfassungssequenz. Die Verzögerung kann beispielsweise größer als 50 ms, größer als 100 ms, größer als 0,5 s, größer als 1 s, größer als 10 s, größer als 1 min oder noch größer sein.

Alternativ können die Aufgaben und Funktionen der weiteren Recheneinheit auch von der Recheneinheit übernommen werden.

Zum Empfangen der Störsignale und des Magnetresonanzsignals kann das MRT-System einen Empfänger aufweisen. Der Empfänger kann beispielsweise Bestandteil der Entstörungseinrichtung sein oder umgekehrt. Der Empfänger kann dabei insbesondere eine Hardware zur analogen und/oder digitalen Hochfrequenzverarbeitung beinhalten, wie beispielsweise einen oder mehrere Verstärker, Mischer oder Filter und/oder eine Bildauswerteeinheit zur späteren Erzeugung des Ortsraumbildes oder sonstiger Abbildungen aus dem entstörten Magnetresonanzsignal.

Um die Simulation der MR-Sequenz des Objekts durchzuführen, kann beispielsweise ein Modell vorgegeben werden, beispielsweise gespeichert auf einer Speichereinheit der Recheneinheit, welches das Ensemble von Kernspins beziehungsweise die entsprechenden erforderlichen Eigenschaften und Parameter definiert und mathematisch beschreibt. Für jeden Kernspin es Ensembles kann beispielsweise eine Bloch-Gleichung und wenigstens näherungsweise numerisch gelöst werden, um das wenigstens eine Simulationssignal zu bestimmen. So kann der entsprechende zu erwartende Beitrag zur Quermagnetisierung des gesamten Kernspinensembles bestimmt werden.

Die Bloch-Gleichungen können dabei räumlich und zeitlich insbesondere im Einklang mit dem Verlauf der MR-Sequenz gelöst werden, welche insbesondere durch einen oder mehrere Anregungspulse, einen oder mehrere Gradientenpulse, eine oder mehrere Auslesezeiträume und so weiter charakterisiert ist. Dabei ist zum Bestimmen des Ruheabschnitts lediglich ein qualitativer Verlauf der Quermagnetisierung erforderlich. So kann der Simulationsaufwand entsprechend begrenzt werden.

Das wenigstens eine Simulationssignal kann also insbesondere ein Signal beinhalten, das den qualitativen Verlauf, insbesondere einen qualitativen zeitlichen und räumlichen Verlauf, der Quermagnetisierung darstellt.

Gemäß zumindest einer Ausführungsform des Verfahrens nach dem verbesserten Konzept wird die Simulation der MR-Sequenz abhängig von wenigstens einer charakteristischen Eigenschaft der Hauptempfangsantenne und/oder abhängig von wenigstens einer charakteristischen Eigenschaft der wenigstens einen Hilfsempfangsantenne durchgeführt.

Die wenigstens eine charakteristische Eigenschaft der Hauptempfangsantenne beziehungsweise der wenigstens einen Hilfsempfangsantenne kann dabei insbesondere ein Empfindlichkeitsprofil der Hauptempfangsantenne beziehungsweise der wenigstens einen Hilfsempfangsantenne beinhalten.

Die Empfindlichkeitsprofile können dabei beispielsweise einer räumlichen Eindringtiefe in das Objekt entsprechen.

Antennen die während der Messung einen geringeren Signalanteil empfangen, beispielsweise weil die Antenne entsprechend weiter von dem Objekt entfernt ist, können einen geringeren Anteil des MR-Signals empfangen, aber beispielsweise ein stärkeres entsprechendes Störsignal. Durch die örtliche Gewichtung der Hauptempfangsantenne und/oder der wenigstens einen Hilfsempfangsantenne oder eine entsprechende Selektion von einzelnen Spulenelementen der Hilfsempfangsantennen beziehungsweise der Hauptempfangsantenne, können die Entstörungsparameter und insbesondere die Gewichtungsfaktoren genauer bestimmt werden.

Gemäß zumindest einer Ausführungsform beinhaltet das wenigstens eine Simulationssignal ein simuliertes MR-Signal und der wenigstens eine Entstörungsparameter wird abhängig von den Analysesignalen und dem simulierten MR-Signal bestimmt.

Im Unterschied zum qualitativen Verlauf der Quermagnetisierung wird also versucht, das tatsächlich mittels der Hauptempfangsantenne empfangene MR-Signal möglichst genau vorherzusagen, wobei hypothetisch davon ausgegangen wird, dass keine externen Störeinflüsse vorhanden wären. Mit anderen Worten kann so das entstörte oder ungestörte MR-Signal näherungsweise prädiziert werden.

Durch die Berücksichtigung des simulierten MR-Signals kann das Risiko reduziert werden, dass bei der Kombination des von der Hauptempfangsantenne empfangenen MR-Signals und den von den wenigstens einen Hilfsempfangsantennen empfangenen Störsignalen tatsächlich korrekte Signalanteile fälschlicherweise entfernt werden. Beispielsweise können Störsignale, die stärker mit dem simulierten MR-Signal korrelieren, weniger stark gewichtet werden, um dies zu erreichen. Dadurch wird die Entstörung beziehungsweise die Rekonstruktion des tatsächlichen MR-Signals mit noch höherer Genauigkeit möglich.

Gemäß zumindest einer Ausführungsform wird mittels der Recheneinheit abhängig von dem wenigstens einen Simulationssignal ein nach dem Ruheabschnitt liegender weiterer Ruheabschnitt der MR-Sequenz bestimmt, wobei während des weiteren Ruheabschnitts der Absolutwert der zu erwartenden MR-Signalamplitude stets kleiner oder gleich dem vorgegebenen Grenzwert ist. Während eines dem weiteren Ruheabschnitt entsprechenden weiteren Analysezeitraums der MR-Sequenz wird mittels der Hauptempfangsantenne und der wenigstens einen Hilfsempfangsantenne jeweils ein weiteres Analysesignal empfangen. Abhängig von den weiteren Analysesignalen wird der wenigstens eine Entstörungsparameter aktualisiert, insbesondere mittels der Entstörungseinrichtung. Mittels der Hauptempfangsantenne wird während der MR-Aufnahme außerhalb des Analysezeitraums und außerhalb des weiteren Analysezeitraums ein weiteres MR-Signal empfangen und mittels der wenigstens einen Hilfsempfangsantenne jeweils ein weiteres Störsignal empfangen. Ein entstörtes weiteres MR-Signal wird, insbesondere mittels der Entstörungseinrichtung, basierend auf dem weiteren MR-Signal, den weiteren Störsignalen und dem wenigstens einen aktualisierten Entstörungsparameter erzeugt.

Durch die Bestimmung mehrerer Ruheabschnitte und der wiederholten Bestimmung beziehungsweise Aktualisierung der Entstörungsparameter werden diese zum einen immer genauer bestimmt, zum anderen kann auch zeitlich veränderbaren Störeinflüssen oder Störquellen Rechnung getragen werden.

Gemäß zumindest einer Ausführungsform werden das MR-Signal und die Störsignale abhängig von dem wenigstens einen Entstörungsparameter kombiniert, um das entstörte MR-Signal zu erzeugen und/oder das weitere MR-Signal und die weiteren Störsignale werden abhängig von dem wenigstens einen aktualisierten Entstörungsparameter kombiniert, um das weitere entstörte MR-Signal zu erzeugen.

Gemäß zumindest einer Ausführungsform enthält der wenigstens eine Entstörungsparameter einen Gewichtungsfaktor für eine Funktion des MR-Signals. Der wenigstens eine Entstörungsparameter enthält für jedes der Störsignale jeweils einen Gewichtungsfaktor für eine Funktion des jeweiligen Störsignals. Das entstörte MR-Signal wird als anhand der Gewichtungsfaktoren gewichtete Summe der Funktion des MR-Signals und der jeweiligen Funktionen der Störsignale erzeugt.

Gemäß zumindest einer Ausführungsform enthält der wenigstens eine Entstörungsparameter jeweils einen Gewichtungsfaktor für das MR-Signal und für jedes der Störsignale. Das entstörte MR-Signal wird als anhand der Gewichtungsfaktoren gewichtete Summe des MR-Signals und der Störsignale erzeugt.

Mit anderen Worten sind die Funktionen in solchen Ausführungsformen alle gleich der Identitätsfunktion, sodass eine Linearkombination realisiert wird.

Gemäß zumindest einer Ausführungsform wird ein Optimierungsverfahren durchgeführt, insbesondere mittels der Entstörungseinrichtung, bei dem die Gewichtungsfaktoren variiert werden, um den wenigstens einen Entstörungsparameter zu bestimmen.

Das Optimierungsverfahren kann beispielsweise ein lineares Optimierungsverfahren oder ein Verfahren gemäß der Methode der kleinsten Quadrate oder ein sonstiges Variationsverfahren beinhalten.

Durch das Optimierungsverfahren kann beispielsweise eine Energie der entsprechend der Gewichtungsfaktoren gewichteten Summe der Analysesignale beziehungsweise Funktionen der Analysesignale minimiert werden.

Gemäß dem verbesserten Konzept wird auch ein MRT-System angegeben, das eine Hauptempfangsantenne, wenigstens eine außerhalb eines Untersuchungsbereichs angeordnete Hilfsempfangsantenne, eine Steuereinheit und eine Recheneinheit aufweist. Die Recheneinheit ist dazu eingerichtet, eine Simulation einer vorgegebenen MR-Sequenz eines Objekts durchzuführen, um wenigstens ein Simulationssignal zu bestimmen, welches einen zeitlichen und räumlichen Verlauf einer Quermagnetisierung eines Ensembles von Kernspins des Objekts betrifft. Die Recheneinheit ist dazu eingerichtet, abhängig von dem wenigstens einen Simulationssignal einen Ruheabschnitt der MR-Sequenz zu bestimmen, wobei während des Ruheabschnitts ein Absolutwert einer zu erwartenden MR-Signalamplitude stets kleiner oder gleich einem vorgegebenen Grenzwert ist. Die Steuereinheit ist dazu eingerichtet, das MRT-System anzusteuern, um eine MR-Aufnahme des Objekts gemäß der MR-Sequenz durchzuführen, wobei während eines dem Ruheabschnitt entsprechenden Analysezeitraums mittels der Hauptempfangsantenne und der wenigstens einen Hilfsempfangsantenne jeweils ein Analysesignal empfangen wird. Die Steuereinheit ist dazu eingerichtet, abhängig von den Analysesignalen wenigstens einen Entstörungsparameter zu bestimmen und ein entstörtes MR-Signal basierend auf einem MR-Signal und Störsignalen und dem wenigstens einen Entstörungsparameter zu erzeugen. Dabei werden während der MR-Aufnahme außerhalb des Analysezeitraums mittels der Hauptempfangsantenne das MR-Signal empfangen und mittels der wenigstens einen Hilfsempfangsantenne jeweils eines der Störsignale.

Die Steuereinheit kann dabei insbesondere die bezüglich des Verfahrens nach dem verbesserten Konzept beschriebene Entstörungseinrichtung beinhalten.

Weitere Ausführungsformen des MRT-Systems nach dem verbesserten Konzept folgen direkt aus den verschiedenen Ausgestaltungsformen des Verfahrens nach dem verbesserten Konzept und umgekehrt. Insbesondere ist ein MRT-System nach dem verbesserten Konzept dazu eingerichtet, ein Verfahren nach dem verbesserten Konzept durchzuführen oder es führt ein solches Verfahren durch.

Gemäß dem verbesserten Konzept wird auch ein Computerprogramm mit Befehlen angegeben. Bei Ausführung des Computerprogramms beziehungsweise der Befehle durch ein MRT-System nach dem verbesserten Konzept bewirken die Befehle, dass das MRT-System ein Verfahren nach dem verbesserten Konzept ausführt.

Gemäß dem verbesserten Konzept wird auch ein computerlesbares Speichermedium angegeben, das ein Computerprogramm nach dem verbesserten Konzept speichert.

Das Computerprogramm sowie das computerlesbare Speichermedium können als Computerprogrammprodukte mit den Befehlen aufgefasst werden.

Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen verwendbar, ohne den Rahmen der Erfindung zu verlassen. Es sind auch Ausführungen und Merkmalskombinationen als offenbart anzusehen, die nicht alle Merkmale eines ursprünglich formulierten unabhängigen Anspruchs aufweisen und/oder die über die in den Rückbezügen der Ansprüche dargelegten Merkmalskombinationen hinausgehen oder von denen abweichen.

In den Figuren zeigen:
- FIG 1: eine schematische Darstellung einer beispielhaften Ausführungsform eines MRT-Systems gemäß dem verbesserten Konzept;
- FIG 2: eine schematische Darstellung eines Teils einer weiteren beispielhaften Ausführungsform eines MRT-Systems nach dem verbesserten Konzept; und
- FIG 3: ein Ablaufdiagramm einer beispielhaften Ausführungsform eines Verfahrens nach dem verbesserten Konzept.

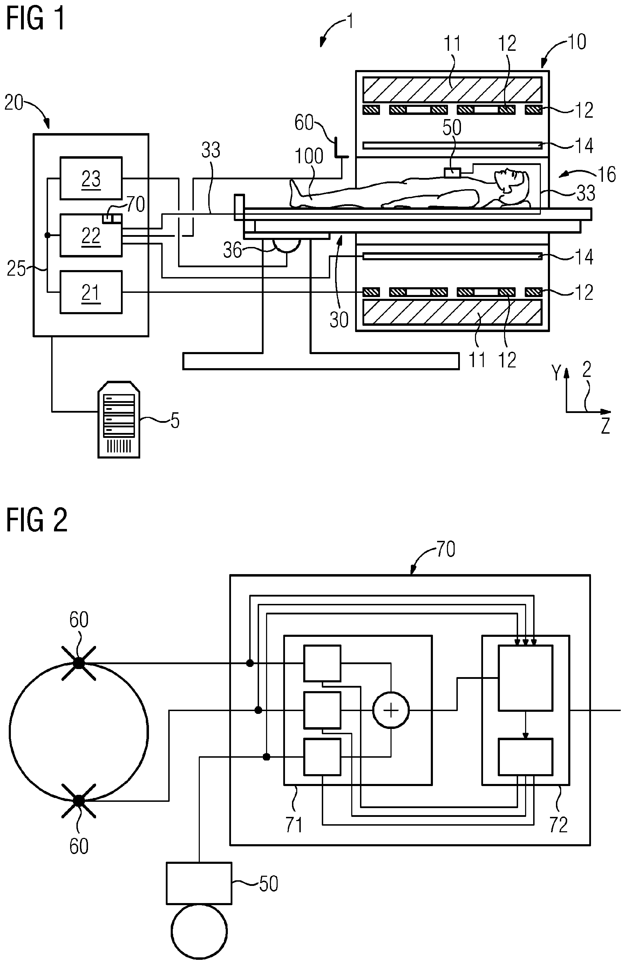

FIG 1 zeigt eine schematische Darstellung einer beispielhaften Ausführungsform eines MRT-Systems 1 gemäß dem verbesserten Konzept.

Das MRT-System 1 weist eine Magneteinheit 10 mit einem Feldmagneten 11 auf, der ein statisches Magnetfeld zur Ausrichtung von Kernspins einer Probe, beispielsweise eines Patienten 100, in einem Untersuchungsbereich oder Aufnahmebereich erzeugt. Der Aufnahmebereich zeichnet sich durch ein äußerst homogenes statisches Magnetfeld auf, wobei die Homogenität insbesondere die Magnetfeldstärke beziehungsweise deren Betrag betrifft. Der Aufnahmebereich ist beispielweise nahezu kugelförmig und in einem Patiententunnel 16 positioniert, der sich in einer Längsrichtung 2 durch die Magneteinheit 10 erstreckt. Bei dem Feldmagneten 11 kann es sich beispielsweise um einen supraleitenden Magneten handelt, der magnetische Felder mit einer magnetischen Flussdichte von bis zu 3 T oder mehr bereitstellen kann. Für geringere Feldstärken können jedoch auch Permanentmagnete oder Elektromagnete mit normalleitenden Spulen Verwendung finden. Eine Patientenliege 30 kann in dem Patiententunnel 16 von einer Verfahreinheit 36 bewegbar sein.

Weiterhin weist die Magneteinheit 10 Gradientenspulen 12 auf, die dazu ausgelegt sind, zur räumlichen Differenzierung der erfassten Abbildungsbereiche in dem Aufnahmebereich dem statischen Magnetfeld ortsabhängige Magnetfelder in den drei Raumrichtungen zu überlagern. Die Gradientenspulen 12 können beispielsweise als Spulen aus normalleitenden Drähten ausgestaltet sein, die beispielsweise zueinander orthogonale Felder oder Feldgradienten in dem Aufnahmebereich erzeugen können.

Die Magneteinheit 10 kann als Sendeantenne beispielsweise eine Körperspule 14 aufweisen, die dazu ausgelegt ist, ein über eine Signalleitung zugeführtes Hochfrequenzsignal in den Untersuchungsbereich abzustrahlen. Die Körperspule 14 kann in manchen Ausführungsformen auch dazu genutzt werden, von dem Patienten 100 emittierte Resonanzsignale zu empfangen und über eine Signalleitung abzugeben. Die Körperspule 14 kann in solchen Ausführungsformen also als Hauptempfangsantenne sowie als Sendeantenne dienen.

Das MRT-System 1 weist eine Steuereinheit 20 auf, die die Magneteinheit 10 mit verschiedenen Signalen für die Gradientenspulen 12 und die Körperspule 14 versorgen kann und die empfangenen Signale auswerten kann. Die Steuereinheit 20 kann beispielsweise eine Gradientensteuerung 21 aufweisen, die dazu ausgelegt ist, die Gradientenspulen 12 über Zuleitungen mit variablen Strömen zu versorgen, welche zeitlich koordiniert die gewünschten Gradientenfelder in dem Untersuchungsbereich bereitstellen können.

Die Steuereinheit 20 kann auch eine Hochfrequenzeinheit 22 aufweisen, die dazu ausgelegt ist, Hochfrequenzpulse oder Anregungspulse mit vorgegebenen zeitlichen Verläufen, Amplituden und spektraler Leistungsverteilung zur Anregung einer Magnetresonanz der Kernspins in dem Patienten 100 zu erzeugen. Dabei können Pulsleistungen im Bereich von Kilowatt eingesetzt werden. Die Anregungspulse können über die Körperspule 14 oder über eine oder mehrere lokale Sendeantennen in den Patienten 100 abgestrahlt werden. Die Steuereinheit 20 kann auch eine Steuerung 23 enthalten, die über einen Signalbus 25 mit der Gradientensteuerung 21 und der Hochfrequenzeinheit 22 kommunizieren kann.

Optional kann in der unmittelbaren Umgebung des Patienten 100, beispielsweise auf dem Patienten 100 oder in der Patientenliege 30, eine Lokalspule 50 angeordnet sein, die über eine Anschlussleitung 33 mit der Hochfrequenzeinheit 22 verbunden sein kann. Je nach Ausgestaltungsform kann die Lokalspule 50 alternativ oder zusätzlich zur Körperspule 14 als Hauptempfangsantenne dienen.

Das MRT-System 1 weist außerdem wenigstens eine Hilfsempfangsantenne 60 auf, die außerhalb des Untersuchungsbereichs, insbesondere außerhalb des Patiententunnels 16, angeordnet ist. Im Beispiel von FIG 1 sind beispielsweise vier Hilfsempfangsantennen 60 an einem Rand der Öffnung des Patiententunnels 16 angeordnet, die an den Ecken eines Quadrats angeordnet sein können, das der kreisförmigen Öffnung eingeschrieben ist, sodass die Ecken auf dem Rand der Öffnung zu liegen kommen. Es sind jedoch auch andere Anordnungen der einen oder mehreren Hilfsempfangsantennen 60 möglich.

Die Hilfsempfangsantennen 60 stehen in einer Signalverbindung mit einem Empfänger 70 der Steuereinheit 20, wobei der Empfänger 70 eine Entstörungseinrichtung 72 beinhaltet, wie beispielsweise in FIG 2 schematisch dargestellt.

Die Hilfsempfangsantennen 60 können jeweils eine Rundumempfangscharakteristik aufweisen, können aber wenigstens zum Teil auch als Dipolantennen ausgestaltet sein und sich gegenseitig durch unterschiedliche Ausrichtung zu einer Rundumcharakteristik ergänzen. Es ist aber auch denkbar, dass eine einzige Hilfsempfangsantenne 60 vorgesehen ist, die beispielsweise eine Rundumcharakteristik aufweist und insbesondere als Kreuzdipol ausgestaltet sein kann.

Der Patient 100 kann, je nach Abmessung des Patiententunnels 16, durch seine endliche Leitfähigkeit als Seele eines Koaxialleiters wirken, dessen Mantel durch eine Wand des Patiententunnels 16 gegeben ist, und so ein an einem Beinende oder Kopfende in den Patienten 100 eingekoppeltes elektromagnetisches Signal in den Untersuchungsbereich weiterleiten. Werden die Hilfsempfangsantennen 60 beispielsweise in der Nähe der Öffnung des Patiententunnels 16 angeordnet, kann dadurch der Einfluss von externen Störern besonders effektiv kompensiert werden.

Das MRT-System weist außerdem eine Recheneinheit 5 auf, die mit der Steuereinheit 20 verbunden ist, insbesondere mit der Hochfrequenzeinheit 22 oder der Entstörungseinrichtung 72.

In FIG 2 ist ein Teil des MRT-Systems 1 aus FIG 1 gezeigt, wobei insbesondere der Empfänger 70 als schematisch dargestellt ist.

Der Empfänger 70 kann beispielsweise eine Summationseinrichtung 71 aufweisen, welche die von der Körperspule 14 und/oder der Lokalspule 50 sowie die von den Hilfsempfangsantennen 60 eingehenden Signale mit Parametern gewichten kann, wobei die Parameter auch komplex sein können, um eine Phasenverschiebung anzugeben. In einem analog ausgestalteten Empfänger 70 kann dies beispielsweise durch einen einstellbaren Verstärker in Verbindung mit einem einstellbaren Phasenschieber erfolgen. Ein Realteil eines Parameters entspricht dann einem Verstärkungsfaktor und ein Imaginärteil des Parameters entspricht der Phasenverschiebung. Nach der Gewichtung werden die Signale entsprechend summiert. Es sind aber auch andere, insbesondere nicht-lineare, Signaloperationen zur Kombination der Einzelsignale denkbar.

Die Entstörungseinrichtung 72 erhält das kombinierte Signal und beispielsweise auch die einzelnen Signale der Lokalspule 50 und/oder der Körperspule 14 beziehungsweise der Hilfsempfangsantennen 60.

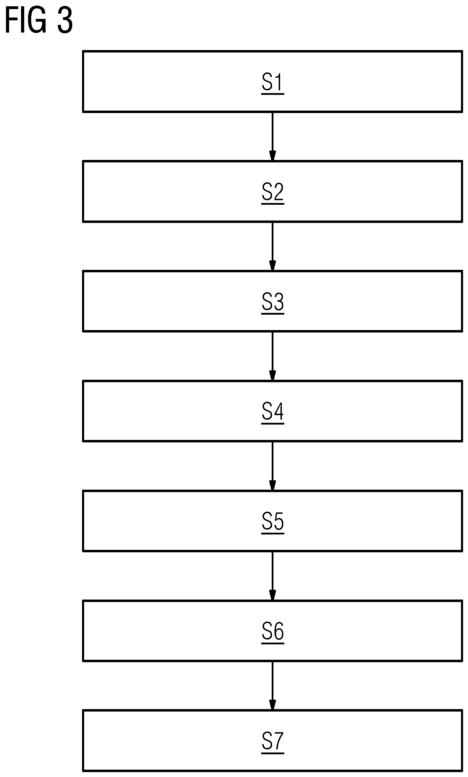

Das MRT-System 1 kann in einer Umgebung mit mehreren Störern die Gewichtungsfaktoren der einzelnen Hilfsempfangsantennen 60 zur Störunterdrückung ermitteln. Um dies genauer zu erläutern, wird die Funktionsweise des MRT-Systems 1 unter Bezugnahme auf FIG 3 anhand einer beispielhaften Ausführungsform eines Verfahrens nach dem verbesserten Konzept genauer erläutert.

In Schritt S1 wird mittels der Recheneinheit 5 eine Simulation einer MR-Sequenz durchgeführt, bei der ein Teil des Patienten 100 als Ensemble von Kernspins beziehungsweise Protonen modelliert wird. Dazu kann beispielsweise eine von einem Nutzer beauftragte Sequenz inklusive einer entsprechenden Parametrisierung zugrunde gelegt werden, also beispielsweise inklusive einer entsprechenden Echozeit TE und/oder einer entsprechenden Wiederholungszeit TR. Ferner werden die räumlichen Anordnungen der Hilfsempfangsantennen 60 sowie der Hauptempfangsantenne 14, 50 berücksichtigt sowie deren elektromagnetische Charakteristika und die beabsichtigte MR-Sequenz. Anhand eines solchen Modells kann die Recheneinheit 5 beispielsweise für jedes Proton eine entsprechende Bloch-Gleichung lösen und so bestimmen, wie die Quermagnetisierung des Kernspinensembles räumlich und zeitlich qualitativ verläuft, insbesondere kontinuierlich verläuft, sprich auch außerhalb der geplanten ADC-Messzeitfenster, welche nur für die Bildgebung relevant sind. Optional kann anhand der Simulation auch das tatsächlich zu erwartende MR-Signal simuliert werden.

Beispielsweise kann die Recheneinheit 5 im Rahmen der Simulation Zeitabschnitte mit hoher MR-Signalintensität, Zeitabschnitte mit niedriger MR-Signalintensität, Zeitabschnitte entsprechend Auslesephasen der Pulssequenz und Zeitabschnitte außerhalb der Auslesephasen der Pulssequenz bestimmen.

Die Simulation kann beispielsweise weiter verfeinert werden, indem Informationen betreffend die Hilfsempfangsantennen 60 beziehungsweise die Hauptempfangsantenne 14, 50 mitberücksichtigt werden, wie beispielsweise Empfindlichkeitsprofile relativ zu der MR-Signalquelle.

Weiterhin kann die Simulation verbessert werden, indem ein angepasstes Modell für die Signalquelle, also den relevanten Bereich des Patienten 100, verwendet wird. Dazu kann beispielsweise berücksichtigt werden, welcher Teil des Patienten 100 untersucht werden soll, welches Geschlecht der Patient 100 hat, welches Körpergewicht und so weiter. Diese Informationen können in die Simulationen zur Lösung der Bloch-Gleichungen eingespeist werden.

In Schritt S2 bestimmt die Recheneinheit 5 abhängig von den Ergebnissen der Simulation, insbesondere abhängig von dem zeitlichen und räumlichen Verlauf der Quermagnetisierung, einen oder mehrere Ruheabschnitte der MR-Sequenz. Die Ruheabschnitte werden dabei derart bestimmt, dass ein Absolutwert einer gemäß der Simulation zu erwartenden MR-Signalamplitude während der Ruheabschnitte stets kleiner oder gleich einem vorgegebenen Grenzwert ist.

Nach der Bestimmung der Ruheabschnitte wird eine MR-Aufnahme des Patienten 100 gemäß der zuvor simulierten MR-Sequenz durchgeführt. In Schritt S3 werden dabei während eines ersten Analysezeitraums, der einem der Ruheabschnitte entspricht, mittels der Hauptempfangsantenne 14, 50 und mittels der Hilfsempfangsantennen 60 jeweils ein Analysesignal empfangen. Indem die Analysesignale während des zuvor aus der Simulation bestimmten Ruheabschnitts empfangen werden, kann davon ausgegangen werden, dass die Analysesignale durch externe Störungen und Hintergrundrauschen dominiert sind.

In Schritt S4 bestimmt die Entstörungseinrichtung 72 daher wenigstens einen Entstörungsparameter basierend auf den während des Analysezeitraums bestimmten Analysesignalen. Der wenigstens eine Entstörungsparameter beinhaltet insbesondere die Gewichtungsfaktoren, welche die Summationseinrichtung 71 einsetzen kann, um das kombinierte Signal zu erzeugen.

In Schritt S5 empfängt die Hauptempfangsantenne 14, 50 während der MR-Aufnahme jedoch nach dem Analysezeitraum ein MR-Signal und die Hilfsempfangsantennen 60 empfangen jeweils ein Störsignal.

In Schritt S6 erzeugt die Entstörungseinrichtung 72 basierend auf dem MR-Signal, den Störsignalen und den zuvor während Schritt S4 bestimmten Entstörungsparametern, insbesondere Gewichtungsfaktoren, das kombinierte Signal, um ein entstörtes MR-Signal zu erhalten. In Schritt S7 kann die Steuereinheit 20 oder die Recheneinheit 5 ein Ortsraumbild basierend auf dem entstörten MR-Signal rekonstruieren.

Die Schritte S3 bis S6 können während einer Messung insbesondere wiederholt oder iterativ durchgeführt werden. Die Messung ist insbesondere heterogen mit Analysezeiträumen und MR-Experimenten besetzt.

Die beschriebene Störquellenunterdrückung kann auch mit einer einzigen Hilfsempfangsantenne 60 ausgeführt werden. Umgekehrt ist es möglich, dass der Empfänger 70 mehrere Kanäle aufweist oder mehrere Empfänger 70 in dem MRT-System 1 vorgesehen sind, um MR-Signale mehrerer Hauptempfangsantennen 14, 50 zu entstören. Dabei ist es denkbar, dass die Signale der Hilfsempfangsantennen 60 von mehreren Empfängern 70 beziehungsweise Kanälen des oder der Empfänger 70 zur Störerunterdrückung genutzt werden.

Wie beschrieben, insbesondere bezüglich der Figuren, wird durch das verbesserte Konzept also eine Möglichkeit zur Störungsreduzierung beim Betrieb eines MRT-Systems angegeben, durch das die Anforderungen an Abschirmvorrichtungen reduziert werden können und das eine zuverlässigere und effektivere Unterdrückung von Störeinflüssen erlaubt.

MRT-Systeme nach dem verbesserten Konzept kommen ohne Abschirmkabinen oder mit weniger aufwendigen Abschirmkabinen aus, sodass die Kosten der Installation und insbesondere einer Neuaufstellung eines Geräts an einem anderen Ort erheblich verringert werden können, da die Installation wesentlich weniger von dem Gebäude abhängt, in dem es installiert wird. Durch gegebenenfalls mehrfache Anpassung der Entstörungsparameter während der MR-Aufnahme können in verschiedenen Ausführungsformen auch räumlich und/oder zeitlich variierende Störquellen berücksichtigt werden. Durch die Simulation der MR-Sequenz können die optimalen Zeiträume zur Bestimmung der Entstörungsparameter für die konkrete MR-Sequenz optimal bestimmt werden.

Dadurch kann a priori die Information bereitgestellt werden, wann die idealen Zeitpunkte oder Zeiträume während der MR-Aufnahme sind, um die Entstörungsparameter zu bestimmen oder zu aktualisieren. Während der durch die Simulation bestimmten Ruhezeiträume ist der Beitrag des tatsächlichen MR-Signals gering, sodass eine verbesserte Korrelation zwischen den Signalen der Hilfsempfangsantennen und der Hauptempfangsantennen möglich ist.

Optional kann auch eine Datenbank mit optimalen Zeiträumen, insbesondere Ruhezeiträumen, für verschiedene MR-Sequenzen erstellt werden, sodass eine schnellere Bestimmung der entsprechenden Zeiträume ermöglicht wird.

Es kann beispielsweise auch ein Grenzwert bestimmt werden, bis zu welchem Grad der Beitrag des simulierten MR-Signals berücksichtigt werden sollte, um eine korrekte Bestimmung der Gewichtungsfaktoren zu ermöglichen. Als Ergebnis kann ein Abtastmuster zur Aktualisierung der Gewichtungsfaktoren bestimmt werden. Wenn sich beispielsweise herausstellt, dass nicht genügend Aktualisierungspunkte zur Erfassung dynamischer Störquellen eingeplant sind, können Rauschabtastungen, insbesondere ohne den Einsatz von MR-Anregungspulsen, in die laufende Akquisition eingefügt werden, beispielsweise zwischen verschiedenen Schichten, um die Aktualisierungsrate zu erhöhen.

Durch das verbesserte Konzept wird also eine deterministische a-priori-Bestimmung der Ruhezeiträume während des MR-Scans genutzt, um optimale Zeitpunkte für die Berechnung der Entstörungsparameter zu erhalten. Durch die Erhöhung der Aktualisierungsrate können dynamische Störquellen besser berücksichtigt werden.

In verschiedenen Ausführungsformen kann auch das tatsächliche MR-Signal anhand von Blocksimulationen simuliert werden und gewissermaßen als zusätzliche Signalquelle zusätzlich zu den Hilfsempfangsantennen und der Hauptempfangsantenne eingesetzt werden.

## Patentansprüche

1. Verfahren zum Betreiben eines Magnetresonanztomographiesystems (1), das eine Hauptempfangsantenne (14, 50) und wenigstens eine außerhalb eines Untersuchungsbereichs (16) angeordnete Hilfsempfangsantenne (60) aufweist, wobei
- mittels einer Recheneinheit (5) eine Simulation einer vorgegebenen MR-Sequenz für ein Objekt (100) durchgeführt wird, um wenigstens ein Simulationssignal zu bestimmen, welches einen zeitlichen und räumlichen Verlauf einer Quermagnetisierung eines Ensembles von Kernspins des Objekts (100) betrifft;
- mittels der Recheneinheit (5) abhängig von dem wenigstens einen Simulationssignal ein Ruheabschnitt der MR-Sequenz bestimmt wird, wobei während des Ruheabschnitts ein Absolutwert einer zu erwartenden MR-Signalamplitude stets kleiner oder gleich einem vorgegebenen Grenzwert ist;
- mittels des Magnetresonanztomographiesystems (1) eine MR-Aufnahme des Objekts (100) gemäß der MR-Sequenz durchgeführt wird, wobei während eines dem Ruheabschnitt entsprechenden Analysezeitraums mittels der Hauptempfangsantenne (14, 50) und der wenigstens einen Hilfsempfangsantenne (60) jeweils ein Analysesignal empfangen wird;
- abhängig von den Analysesignalen wenigstens ein Entstörungsparameter bestimmt wird;
- mittels der Hauptempfangsantenne (14, 50) während der MR-Aufnahme außerhalb des Analysezeitraums ein MR-Signal empfangen wird und mittels der wenigstens einen Hilfsempfangsantenne (60) jeweils ein Störsignal empfangen wird; und
- ein entstörtes MR-Signal basierend auf dem MR-Signal, den Störsignalen und dem wenigstens einen Entstörungsparameter erzeugt wird.

2. Verfahren nach Anspruch 1,
**dadurch gekennzeichnet, dass**
für jeden Kernspin des Ensembles eine Bloch-Gleichung numerisch wenigstens näherungsweise gelöst wird, um das wenigstens eine Simulationssignal zu bestimmen.

3. Verfahren nach einem der vorhergehenden Ansprüche,
**dadurch gekennzeichnet, dass**
die Simulation abhängig von wenigstens einer charakteristischen Eigenschaft der Hauptempfangsantenne (14, 50) durchgeführt wird.

4. Verfahren nach Anspruch 3,
**dadurch gekennzeichnet, dass**
die wenigstens eine charakteristische Eigenschaft der Hauptempfangsantenne (14, 50) ein Empfindlichkeitsprofil der Hauptempfangsantenne (14, 50) beinhaltet.

5. Verfahren nach einem der vorhergehenden Ansprüche,
**dadurch gekennzeichnet, dass**
die Simulation abhängig von wenigstens einer charakteristischen Eigenschaft der wenigstens einen Hilfsempfangsantenne (60) durchgeführt wird.

6. Verfahren nach Anspruch 5,
**dadurch gekennzeichnet, dass**
die wenigstens eine charakteristische Eigenschaft der Hilfsempfangsantenne (60) ein Empfindlichkeitsprofil der wenigstens einen Hilfsempfangsantenne (60) beinhaltet.

7. Verfahren nach einem der vorhergehenden Ansprüche,
**dadurch gekennzeichnet, dass**
- das wenigstens eine Simulationssignal ein simuliertes MR-Signal beinhaltet; und
- der wenigstens eine Entstörungsparameter abhängig von den Analysesignalen und dem simulierten MR-Signal bestimmt wird.

8. Verfahren nach einem der vorhergehenden Ansprüche,
**dadurch gekennzeichnet, dass**
- mittels der Recheneinheit (5) abhängig von dem wenigstens einen Simulationssignal ein nach dem Ruheabschnitt liegender weiterer Ruheabschnitt der MR-Sequenz bestimmt wird, wobei während des weiteren Ruheabschnitts der Absolutwert der zu erwartenden MR-Signalamplitude stets kleiner oder gleich dem vorgegebenen Grenzwert ist; und
- während eines dem weiteren Ruheabschnitt entsprechenden weiteren Analysezeitraums der MR-Sequenz mittels der Hauptempfangsantenne (14, 50) und der wenigstens einen Hilfsempfangsantenne (60) jeweils ein weiteres Analysesignal empfangen wird;
- abhängig von den weiteren Analysesignalen der wenigstens eine Entstörungsparameter aktualisiert wird;
- mittels der Hauptempfangsantenne (14, 50) während der MR-Aufnahme außerhalb des Analysezeitraums und des weiteren Analysezeitraums ein weiteres MR-Signal empfangen wird und mittels der wenigstens einen Hilfsempfangsantenne (60) jeweils ein weiteres Störsignal empfangen wird; und
- ein entstörtes weiteres MR-Signal basierend auf dem weiteren MR-Signal, den weiteren Störsignalen und dem wenigstens einen aktualisierten Entstörungsparameter erzeugt wird.

9. Verfahren nach einem der vorhergehenden Ansprüche,
**dadurch gekennzeichnet, dass**
das MR-Signal und die Störsignale abhängig von dem wenigstens einen Entstörungsparameter kombiniert werden, um das entstörte MR-Signal zu erzeugen.

10. Verfahren nach einem der vorhergehenden Ansprüche,
**dadurch gekennzeichnet, dass**
- der wenigstens eine Entstörungsparameter einen Gewichtungsfaktor für eine Funktion des MR-Signals beinhaltet;
- der wenigstens eine Entstörungsparameter für jedes der Störsignale jeweils einen Gewichtungsfaktor für eine Funktion des jeweiligen Störsignals beinhaltet; und
- das entstörte MR-Signal als anhand der Gewichtungsfaktoren gewichtete Summe der Funktion des MR-Signals und der jeweiligen Funktionen der Störsignale erzeugt wird.

11. Verfahren nach einem der Ansprüche 1 bis 9,
**dadurch gekennzeichnet, dass**
- der wenigstens eine Entstörungsparameter jeweils einen Gewichtungsfaktor für das MR-Signal und jedes der Störsignale beinhaltet; und
- das entstörte MR-Signal als anhand der Gewichtungsfaktoren gewichtete Summe des MR-Signals und der Störsignale erzeugt wird.

12. Verfahren nach einem der Ansprüche 10 oder 11,
**dadurch gekennzeichnet, dass**
ein Optimierungsverfahren durchgeführt wird, bei dem die Gewichtungsfaktoren variiert werden, um den wenigstens einen Entstörungsparameter zu bestimmen.

13. Verfahren nach einem der vorhergehenden Ansprüche,
**dadurch gekennzeichnet, dass**
ein Ortsraumbild abhängig von dem entstörten MR-signal erzeugt wird.

14. Magnetresonanztomographiesystem aufweisend eine Hauptempfangsantenne (14, 50), wenigstens eine außerhalb eines Untersuchungsbereichs (16) angeordnete Hilfsempfangsantenne (60), eine Steuereinheit (20) und eine Recheneinheit (5), die dazu eingerichtet ist,
- eine Simulation einer vorgegebenen MR-Sequenz eines Objekts (100) durchzuführen, um wenigstens ein Simulationssignal zu bestimmen, welches einen zeitlichen und räumlichen Verlauf einer Quermagnetisierung eines Ensembles von Kernspins des Objekts (100) betrifft;
- abhängig von dem wenigstens einen Simulationssignal einen Ruheabschnitt der MR-Sequenz zu bestimmen, wobei während des Ruheabschnitts dem ein Absolutwert einer zu erwartenden MR-Signalamplitude stets kleiner oder gleich einem vorgegebenen Grenzwert ist;
wobei die Steuereinheit (20) dazu eingerichtet ist,
- das Magnetresonanztomographiesystem (1) anzusteuern, um eine MR-Aufnahme des Objekts (100) gemäß der MR-Sequenz durchzuführen, wobei während eines dem Ruheabschnitt entsprechenden Analysezeitraums mittels der Hauptempfangsantenne (14, 50) und der wenigstens einen Hilfsempfangsantenne (60) jeweils ein Analysesignal empfangen wird;
- abhängig von den Analysesignalen wenigstens einen Entstörungsparameter zu bestimmen; und
- ein entstörtes MR-Signal basierend auf einem MR-Signal und Störsignalen und dem wenigstens einen Entstörungsparameter zu erzeugen, wobei während der MR-Aufnahme außerhalb des Analysezeitraums mittels der Hauptempfangsantenne (14, 50) das MR-Signal empfangen wird und mittels der wenigstens einen Hilfsempfangsantenne (60) jeweils eines der Störsignale empfangen wird.

15. Computerprogrammprodukt mit Befehlen, die bei Ausführung durch ein Magnetresonanztomographiesystem (1) nach Anspruch 14, das Magnetresonanztomographiesystem (1) dazu veranlassen, ein Verfahren nach einem der Ansprüche 1 bis 13 durchzuführen.
